(19) **Europäisches Patentamt / European Patent Office / Office européen des brevets**

(11) **EP 4 556 921 A1**

(12) **EUROPEAN PATENT APPLICATION**
published in accordance with Art. 153(4) EPC

(43) Date of publication:
**21.05.2025 Bulletin 2025/21**

(21) Application number: **23870619.6**

(22) Date of filing: **22.09.2023**

(51) International Patent Classification (IPC):
**G01R 31/382** (2019.01)     **G01R 31/392** (2019.01)

(86) International application number:
**PCT/CN2023/120636**

(87) International publication number:
**WO 2024/067388 (04.04.2024 Gazette 2024/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **26.09.2022  CN 202211177285**

(71) Applicant: **Deepal Automobile Technology Co., Ltd.**
**Chongqing 401133 (CN)**

(72) Inventors:
• **WU, Zhengguo**
  **Chongqing 401135 (CN)**

• **LI, Dongjiang**
  **Chongqing 401135 (CN)**
• **YI, Bingxi**
  **Chongqing 401135 (CN)**
• **ZHENG, Changwen**
  **Chongqing 401135 (CN)**
• **JIANG, Zhenwen**
  **Chongqing 401135 (CN)**

(74) Representative: **2K Patentanwälte Blasberg Kewitz & Reichel**
**Partnerschaft mbB**
**Schumannstrasse 27**
**60325 Frankfurt am Main (DE)**

(54) **METHOD AND SYSTEM FOR ESTIMATING STATE OF HEALTH OF BATTERY, AND DEVICE AND MEDIUM**

(57)     A method and system for estimating the state of health of a battery, and a device and a medium. The method comprises: acquiring charging data of each battery cell in a plurality of charging segments within a preset time period, wherein each charging segment corresponds to a continuous charging time period (S300); determining, according to the charging data, a first relational expression between a state of charge and an electromotive force in a corresponding charging segment (S310); constructing a target loss function according to the first relational expression and a preset second relational expression between the state of charge and the electromotive force, and performing optimization according to the target loss function to obtain an optimal rechargeable electric quantity of a charging segment corresponding to the minimum target loss function (S320); and determining the current state of health of a battery pack according to the optimal rechargeable electric quantity of each charging segment, wherein the battery pack is composed of a plurality of batteries (S330). The method can effectively ensure the accuracy of estimating the state of health of a battery.

FIG. 3

**Description**

TECHNICAL FIELD

This application relates to the field of power batteries, and in particular, to a method and a system for estimating a state of health of a battery, and a device and a medium.

BACKGROUND

A state of health SOH (state of health) reflects an attenuation degree of a present capacity of a power battery, and main characterization parameters thereof are a capacity and an internal resistance. Currently, a battery management system usually takes capacity attenuation as a characteristic index of an SOH of a power battery of a new energy vehicle. Precise estimation of the SOH facilitates safe use and maintenance of the power battery, further improves SOC estimation precision, and facilitates evaluation of the value of a used vehicle. Usually, an in-vehicle BMS calculates a present SOH value of a vehicle. However, the vehicle cannot store a large amount of data due to a hardware limitation. In addition, an SOH is closely related to a strategy of the battery management system. To ensure accuracy of the SOH, a condition for triggering updating of the SOH value on a vehicle side is extremely strict, which may lead to failure to update the SOH value in time on the vehicle side, causing the battery management system to inaccurately estimate a state of a power battery or even take an improper charging/discharging strategy.

SUMMARY

In view of the foregoing problems in the conventional technology, this application provides a method and a system for estimating a state of health of a battery, a device, and a medium, to mainly resolve a problem of poor accuracy in estimation of a state of health of a battery in an existing method.

To achieve the foregoing objective and other objectives, the following technical solutions are used in this application.

This application provides a method for estimating a state of health of a battery, the method includes:

obtaining charging data of battery cells in a plurality of charging segments within a preset time period, where each charging segment corresponds to one consecutive charging time period;

determining a first relational expression between a state of charge and an electromotive force in a corresponding charging segment according to the charging data;

constructing a target loss function according to the first relational expression and a preset second relational expression between the state of charge and the electromotive force, and performing optimization according to the target loss function, to obtain an optimal chargeable capacity of the corresponding charging segment when the target loss function reaches a minimum value; and

determining a present state of health of a battery pack according to optimal chargeable capacities of the charging segments, where the battery pack includes a plurality of battery cells.

In an embodiment of this application, after the present state of health of the battery pack is determined according to the optimal chargeable capacities of the charging segments, the method further includes:

obtaining charging data of a latest charging segment of the battery pack, and determining a present state of charge corresponding to the battery pack according to the charging data of the latest charging segment and the present state of health; and

outputting the present state of charge and the present state of health to a vehicle-side battery management system.

In an embodiment of this application, the determining a present state of charge corresponding to the battery pack according to the charging data of the latest charging segment and the present state of health includes:

determining a present chargeable capacity of the battery pack according to a product of the present state of health and a preset rated battery capacity;

determining an accumulative charged capacity of the battery pack in the latest charging segment according to the charging data of the latest charging segment; and

calculating the present state of charge according to the present chargeable capacity and the accumulative charged capacity.

In an embodiment of this application, before the charging data of the battery cells in the plurality of charging segments within the preset time period is obtained, the method further includes:

obtaining test data of batteries at a standard operating condition, where the test data includes charged capacities and voltages of the battery cells at different temperatures and currents, and determining states of charge of the battery cells at a corresponding time node according to the charged capacities;

generating voltage curves at different temperatures, currents, and states of charge according to the voltages in the test data;

determining electromotive force curves corresponding to the battery cells in different states of charge according to the voltage curves; and

determining battery cell internal resistances at different temperatures, currents, and states of charge according to differences between the electromotive force curves and the voltage curves.

In an embodiment of this application, the determining electromotive force curves corresponding to the battery cells in different states of charge according to the voltage curves includes:

performing interpolation on the voltage curves to obtain curves at different temperatures and a current of zero as the electromotive force curves in different states of charge.

In an embodiment of this application, the determining a first relational expression between a state of charge and an electromotive force in a corresponding charging segment according to the charging data includes:

selecting a node of a charging start stage of each charging segment as an initial node, and obtaining a real state of charge at the initial node as an initial state of charge;

determining states of charge at different time nodes of the corresponding charging segment according to the initial state of charge, an accumulative charged capacity, and battery chargeable capacities at different time nodes, where the accumulative charged capacity is obtained through ampere-hour integration;

determining battery internal resistances at corresponding time nodes according to states of charge, currents, and temperatures at different time nodes; and

determining electromotive force values at the corresponding time nodes according to the battery cell internal resistances, currents, and corresponding voltage values at the corresponding time nodes, to obtain the first relational expression between the state of charge and the electromotive force in the corresponding charging segment, where the initial state of charge, the currents, the voltage values, and the temperatures are included in charging data of the corresponding charging segment.

In an embodiment of this application, the determining a present state of health of a battery pack according to optimal chargeable capacities of the charging segments includes:

performing filtering based on optimal charged capacities of the charging segments to obtain a filtered charged capacity of the battery pack; and

determining the present state of health of the battery pack according to a ratio of the filtered charged capacity of the battery pack to a preset rated capacity of the battery pack.

In an embodiment of this application, before the present state of health of the battery pack is determined according to the ratio of the filtered charged capacity of the battery pack to the preset rated capacity of the battery pack, the method further includes:

obtaining charging data of the battery pack within a preset use period in which the battery pack is just put into use;

obtaining a total capacity of the battery pack according to the charging data of the battery pack; and

updating the rated capacity of the battery pack according to the total capacity to complete capacity calibration.

In an embodiment of this application, the constructing a target loss function according to the first relational expression and a preset second relational expression between the state of charge and the electromotive force, and performing optimization according to the target loss function includes:

constructing the target loss function according to a square difference between the first relational expression and the second relational expression; and

using initial states of charge and rated capacities of the charging segments that are uploaded by a system at an initial moment as start nodes for calculation, and calculating optimal initial states of charge and optimal chargeable capacities corresponding to the charging segments according to a gradient descent method, so that a value of the target loss function is minimized.

This application further provides a system for estimating a state of health of a battery, the system includes:

a charging data obtaining module, configured to obtain charging data of battery cells in a plurality of charging segments within a preset time period, where each charging segment corresponds to one consecutive charging time period;

an electromotive force determining module, configured to determine a first relational expression between a state of charge and an electromotive force in a corresponding charging segment according to the charging data;

an optimization module, configured to construct a target loss function according to the first relational expression and a preset second relational expression between the state of charge and the electromotive force, and perform optimization according to the target loss function, to obtain an optimal chargeable capacity of the corresponding charging segment when the target loss function reaches a minimum value; and

a state evaluation module, configured to determine a present state of health of a battery pack according to optimal chargeable capacities of the charging segments, where the battery pack includes a plurality of battery cells.

This application further provides a computer device, including a memory, a processor, and a computer program stored in the memory and capable of running on the processor. The steps of the method for estimating a state of health of a battery are implemented when the processor executes the computer program.

This application further provides a computer-readable storage medium having a computer program stored therein, where the steps of the method for estimating a state of health of a battery are implemented when the computer program is executed by a processor.

As described above, the method and system for estimating a state of health of a battery, the device, and the medium of this application have the following beneficial effects.

In this application, the charging data of the battery cells in the plurality of charging segments within a preset time period is obtained, where each charging segment corresponds to one consecutive charging time period; the first relational expression between the state of charge and the electromotive force in the corresponding charging segment is determined according to the charging data; the target loss function is constructed according to the first relational expression and the preset second relational expression between the state of charge and the electromotive force, and optimization is performed according to the target loss function, to obtain the optimal chargeable capacity of the corresponding charging segment when the target loss function reaches the minimum value; and the present state of health of the battery pack is determined according to the optimal chargeable capacities of the charging segments. In this application, state of health evaluation is performed based on historical charging data of the battery, thereby effectively improving estimation precision of the state of health without being limited by conditions such as a temperature and a voltage, facilitating updating of an initial state of charge on a vehicle side based on the estimated state of health, and enabling the battery management system to provide a more proper charging/discharging strategy.

BRIEF DESCRIPTION OF DRAWINGS

FIG. 1 is a schematic diagram of an application scenario of a system for estimating a state of health of a battery according to an embodiment of this application;

FIG. 2 is a schematic diagram of a structure of a terminal according to an embodiment of this application;

FIG. 3 is a schematic flowchart of a method for estimating a state of health of a battery according to an embodiment of this application;

FIG. 4 is a schematic flowchart of overall estimation of a state of health of a battery according to another embodiment of this application;

FIG. 5 is a schematic diagram of calculating different charging curves and electromotive forces of a battery at a specific temperature according to an embodiment of this application;

FIG. 6 is a schematic diagram of calculating a capacity of a battery cell according to an embodiment of this application;

FIG. 7 is a module diagram of a system for estimating a state of health of a battery according to an embodiment of this application; and

FIG. 8 is a schematic diagram of a structure of a device according to an embodiment of this application.

DESCRIPTION OF EMBODIMENTS

The following describes implementations of this application by using specific embodiments. A person skilled in the art may easily learn of other advantages and effects of this application based on content disclosed in this specification. This application can be further implemented or applied in some other different specific implementations. Various details in this specification can also be modified or altered based on different viewpoints and applications without departing from this application. It should be noted that the following embodiments and features in the embodiments may be mutually combined when there are no conflicts.

It should be noted that, the illustrations provided in the following embodiments merely describe the basic concept of this application by using examples. Although the drawings show only components related to this application, and are not drawn based on a quantity of components, a shape of a component, and a size of a component during actual implementation, a shape, a quantity, and a scale of the components may be arbitrarily changed during actual implementation, and a component layout form may be more complex.

In a method for estimating a state of health in the conventional technology, data during direct current charging of a power battery is usually collected to calculate, through ampere-hour integration, a real-time capacity meeting an optimal condition. A ratio of an average capacity to a rated capacity of each month is calculated to obtain a relative SOH, and then a fitted curve of the SOH is obtained in a polynomial fitting manner and continuously updated. A deviation exists in performing ampere-hour integration based on cloud current data, and an estimation deviation exists in vehicle-side SOC estimation. Therefore, deviation accumulation occurs when an SOH value is back-calculated based on a vehicle-side SOC value, resulting in an inaccurate estimated SOH value.

Based on the problem in the conventional technology, this application provides a method and a system for estimating a state of health of a battery, a device, and a medium. The following describes in detail the technical solutions of this application with reference to specific embodiments.

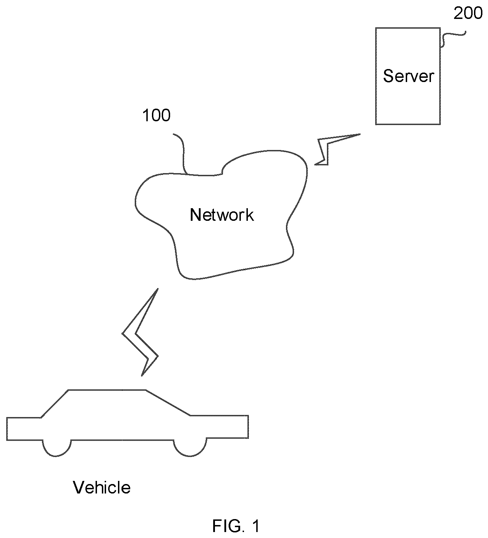

FIG. 1 is a schematic diagram of an application scenario of a system for estimating a state of health of a battery according to an embodiment of this application. A vehicle-side system corresponding to a vehicle may collect data during each time of charging of an electric vehicle, such as a charging start time and a charging end time, and a temperature of a battery, a battery voltage, a charging current, and a charged capacity in a charging process. An initial state of charge of the vehicle may be retrieved, before each time the vehicle is charged, from a cloud server 200 as an initial state of charge reference data of a present charging start stage. The vehicle uploads the collected charging data to a battery data management platform on the cloud through a network 100. The battery data management platform is disposed at the server 200, and is configured to manage the charging data uploaded by the vehicle, for example, divide historical charging data into a plurality of charging segments based on each consecutive charging time period, so that each charging segment corresponds to one consecutive charging time period. Data cleaning may be further performed to remove invalid data or other interference data. The server 200 may store a rated capacity of a battery pack, test data before battery delivery, and the like that are uploaded by a battery supplier, and generate, based on the test data, a voltage-capacity curve and an electromotive force-capacity curve that correspond to the battery pack. The test data may be obtained through statistics collection for charging/discharging data of a battery at different temperature and current conditions at a standard operating condition.

In an embodiment, the server 200 may be an independent physical server, may be a server cluster or a distributed system formed by a plurality of physical servers, or may be a cloud server that provides basic cloud computing services such as a cloud service, a cloud database, cloud computing, a cloud function, cloud storage, a network service, cloud communication, a middleware service, a domain name service, a security service, a CDN, and a big data and artificial intelligence platform.

In an embodiment, an accumulative charged capacity corresponding to the charging segments may also be calculated on a vehicle side through ampere-hour integration, and the accumulative charged capacity is uploaded to the server 200 through the network 100, thereby avoiding an error in calculating the accumulative charged capacity through the server 200 on the cloud. In another embodiment, the terminal may be a smartphone, a tablet computer, a notebook computer, a desktop computer, a smart sound box, a smart watch, a smart voice interaction device, a smart home appliance, an in-vehicle terminal, or the like, but is not limited thereto.

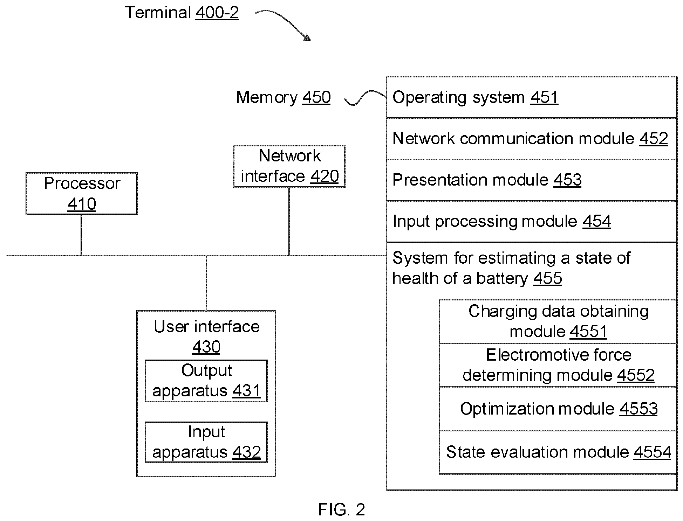

FIG. 2 is a schematic diagram of a structure of a terminal 400 according to an embodiment of this application. The terminal 400 shown in FIG. 2 includes at least one processor 410, a memory 450, at least one network interface 420, and a user interface 430. The components in the terminal 400 are coupled together through a bus system 440. It can be understood that the bus system 440 is configured to implement connection and communication between these components. In addition to a data bus, the bus system 440 further includes a power bus, a control bus, and a status signal bus. However, for clear description, various buses are marked as the bus system 440 in FIG. 2.

The processor 410 may be an integrated circuit chip and has a signal processing capability, for example, a general-purpose processor, a digital signal processor (DSP, Digital Signal Processor), another programmable logic device, a discrete gate or a transistor logic device, or a discrete hardware component. The general-purpose processor may be a microprocessor, any conventional processor, or the like.

The user interface 430 includes one or more output apparatuses 431 that enable presentation of media content, including one or more loudspeakers and/or one or more visual displays. The user interface 430 further includes one or more input apparatuses 432, including user interface components that facilitate user input, such as a keyboard, a mouse, a microphone, a touchscreen display, a camera, another input button, and a control.

The memory 450 may be removable, non-removable, or a combination thereof. An exemplary hardware device includes a solid-state memory, a hard disk drive, an optical disk drive, or the like. The memory 250 may optionally include one or more storage devices that are physically away from the processor 410.

The memory 450 includes a volatile memory or a non-volatile memory, or may include both the volatile memory and the non-volatile memory. The non-volatile memory may be a read-only memory (ROM, Read Only Memory), and the volatile memory may be a random access memory (RAM, Random Access Memory). The memory 450 described in this embodiment of this application is intended to include any suitable type of memory.

In some embodiments, the memory 450 can store data to support various operations, examples of the data include programs, modules, and data structures, or subsets or supersets thereof, as exemplified below.

An operating system 451 includes system programs used for processing various basic system services and performing hardware-related tasks, such as a framework layer, a kernel library layer, and a driver layer, to implement various basic services and process hardware-based tasks.

A network communication module 452 is configured to reach another computing device through one or more (wired or wireless) network interfaces 420. Exemplary network interfaces 420 include Bluetooth, wireless fidelity (Wi-Fi), and a universal serial bus (USB, Universal Serial Bus).

A presentation module 453 is configured to enable presentation of information (for example, a user interface configured to operate a peripheral device and display content and information) through the one or more output apparatuses 431 (for example, the display and the loudspeaker) associated with the user interface 430.

An input processing module 454 is configured to detect and translate one or more user inputs or interactions from the one or more input apparatuses 432.

In some embodiments, the apparatuses provided in this embodiment of this application may be implemented in a software manner. FIG. 2 shows a system 455 for estimating a state of health of a battery that is stored in the memory 450, which may be software in a form of a program, a plug-in, or the like, and includes the following software modules: a charging data obtaining module 4551, an electromotive force determining module 4552, an optimization module 4553, and a state evaluation module 4554. These modules are logically implemented, and therefore, may be arbitrarily combined or further split based on functions implemented thereby.

Functions of the modules are described below.

In some other embodiments, the system provided in this embodiment of this application may be implemented in a hardware manner. For example, the system provided in this embodiment of this application may be a processor in a form of a hardware decoding processor, which is programmed to perform a method for estimating a state of health of a battery provided in the embodiments of this application. For example, the processor in the form of a hardware decoding processor may be one or more application specific integrated circuits (ASIC, Application Specific Integrated Circuit), a DSP, a programmable logic device (PLD, Programmable Logic Device), a complex programmable logic device (CPLD, Complex-Programmable Logic Device), a field programmable gate array (FPGA, Field-Programmable GateArray), or another electronic component.

In some embodiments, the terminal or the server may implement, by running a computer program, the method for estimating a state of health of a battery provided in the embodiments of this application. For example, the computer program may be a native program or a software module in an operating system, may be a native (Native) application (APP, Application), that is, a program that needs to be installed in the operating system to run, such as a social application APP or a message share APP, may be an applet, that is, a program that can be run after being downloaded to a browser environment, or may be an applet or a web client program that can be embedded into any APP. In conclusion, the foregoing computer program may be an application, a module, or a plug-in in any form.

The following describes the method for estimating a state of health of a battery provided in the embodiments of this application with reference to exemplary application and implementation of a device provided in the embodiments of this application.

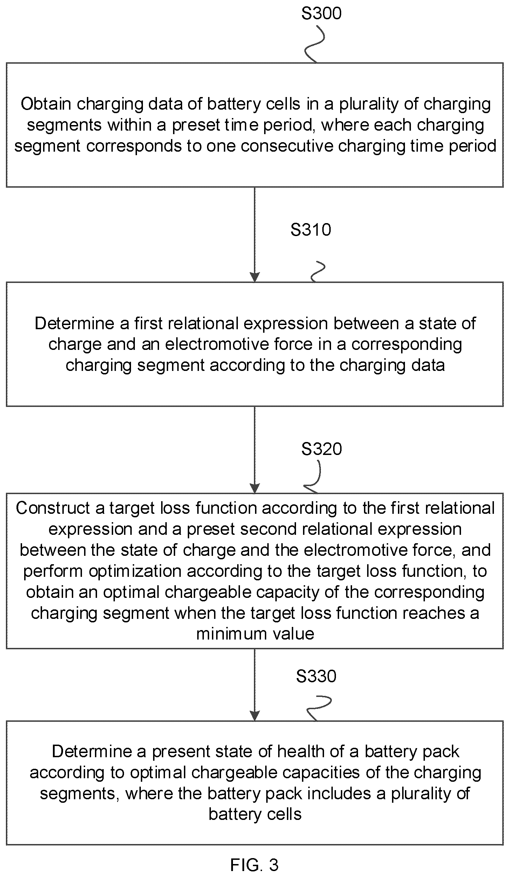

Refer to FIG. 3. This application provides a method for estimating a state of health of a battery. The method includes the following steps.

Step S300: Obtain charging data of battery cells in a plurality of charging segments within a preset time period, where each charging segment corresponds to one consecutive charging time period.

In an embodiment, charging data uploaded by a vehicle may be stored in a cloud platform, and the charging data may include data such as a charging time, a charging current, a battery voltage, a battery temperature, and an accumulative charged capacity.

In an embodiment, before the charging data of the battery cells in the plurality of charging segments within the preset time period is obtained, the method further includes the following steps.

Step S301: Obtain test data of batteries at a standard operating condition, where the test data includes charged capacities and voltages of the battery cells at different temperatures and currents, and determine states of charge of the battery cells at a corresponding time node according to the charged capacities.

In an embodiment, during project development, a capacity of the battery at the standard operating condition is tested, constant-current charging curves of the battery at different temperatures and different current conditions are obtained through testing, and temperatures, charging currents, charged capacities, and voltages of the battery are recorded, where the temperatures and charging current ranges should be greater than a temperature interval for battery use, and the charging currents should be set more densely in a small current interval, to ensure accuracy of calculating an electromotive force curve subsequently.

S302: Determine electromotive force curves corresponding to the battery cells in different states of charge according to the voltage curves.

In an embodiment, an electromotive force-capacity curve (EMF curve) of the battery is estimated by using an extrapolation estimation method according to a formula U=EMF+I·R (SOC, T, I), and a value R (SOC, T, I) of a battery internal resistance at different SOCs, different temperatures, and different current conditions is calculated according to the charging curves and EMF curves.

Step S303: Determine battery cell internal resistances at different temperatures, currents, and states of charge according to differences between the electromotive force curves and the voltage curves.

In an embodiment, determining of the electromotive force curves corresponding to the battery cells in different states of charge according to the voltage curves includes:

performing interpolation on the voltage curves to obtain curves at different temperatures and a current of zero as the electromotive force curves in different states of charge.

Specifically, the voltage curves of the battery at the current of 0 and different charged capacities are estimated by using the extrapolation estimation method. The curves are the electromotive force-capacity curves (EMF curves) of the battery. In addition, the value R (SOC, T, I) of the battery internal resistance at different SOCs, different temperatures, and different current conditions is calculated according to the charging curves and the EMF curves. In the formula, U represents a voltage, and EMF represents an electromotive force of the battery. In an embodiment, a voltage existing when the current is 0 may be preliminarily estimated through extrapolation as an electromotive force EMF value. The extrapolation method may be linear interpolation or another interpolation method. A reason for using this method to calculate the EMF curve instead of calculating a voltage through resting is that a long test time is required for measuring an open-circuit voltage of the battery after resting and there are limited measurement points. Therefore, a test time can be greatly shortened by calculating the EMF curve according to a method of performing extrapolation on the charging curve.

Step S304: Determine battery internal resistances at different temperatures, currents, and states of charge according to differences between the electromotive force curves and the voltage curves.

In an embodiment, R (SOC, I, T) represents the battery internal resistances at different SOCs, different currents, and different temperatures, and a product of R (SOC, I, T) and a current is a difference between the voltage curve and the EMF curve. This value is less affected by the current. Therefore, an impact of the current can be ignored during calculation.

Further, the charging data uploaded by the vehicle to the cloud platform of the Internet of Vehicles may be extracted. Extracted fields include "current", "voltage", "time", "battery SOC", "accumulative charged capacity", and the like. "Accumulative charged capacity" is not a required field according to the national standard (GBT32960), and this field may be requested to be added and uploaded by the vehicle side.

Data cleaning is performed on the extracted fields to remove invalid data. The charging data is divided, each consecutive charging time period is used as a charging segment, m charging segments are obtained through division, these charging segments are sorted by time, and serial numbers are sequentially 1, 2, ..., and m.

Accumulative charged capacities of different charging segments at different time nodes are calculated. A frequency at which the vehicle side calculates the accumulative charged capacities is high and accuracy is high. Alternatively, data of the cloud platform of the Internet of Vehicles may be used to calculate the accumulative charged capacities, and charged capacities are calculated by using an ampere-hour integration method, where a discrete data integration method is used. It is assumed that there are n rows of charging data in total, and time nodes are denoted as $t_1$, $t_2$,

$$Q_1 = \sum_{i=1}^{n-1} \left( \frac{1}{2} (I_i + I_{i+1})) \times (t_{i+1} - t_i) \right.$$

$\cdots$, and $t_n$, and currents are denoted as $I_1$, $I_2$, $\cdots$, and $I_n$. Then, the charged capacity is ). However, the cloud data requires a long transmission cycle due to a bandwidth limitation, resulting in ordinary calculation accuracy. A specific selection of a location for calculating the accumulative charged capacity may be set according to an actual application requirement. This is not limited herein.

Step S310: Determine a first relational expression between a state of charge and an electromotive force in a corresponding charging segment according to the charging data.

In an embodiment, determining of the first relational expression between the state of charge and the electromotive force in the corresponding charging segment according to the charging data includes:

selecting a node of a charging start stage of each charging segment as an initial node, and obtaining a real state of charge at the initial node as an initial state of charge;

determining states of charge at different time nodes of the corresponding charging segment according to the initial state of charge, an accumulative charged capacity, and battery chargeable capacities at different time nodes, where the accumulative charged capacity is obtained through ampere-hour integration;

determining battery cell internal resistances at corresponding time nodes according to states of charge, currents, and temperatures at different time nodes; and

determining electromotive force values at the corresponding time nodes according to the battery cell internal resistances, currents, and corresponding voltage values at the corresponding time nodes, to obtain the first relational expression between the state of charge and the electromotive force in the corresponding charging segment, where the initial state of charge, the currents, the voltage values, and the temperatures are included in charging data of the corresponding charging segment.

Specifically, each cell is separately calculated for the data during each time of charging. The node of the charging start stage is selected as the initial node for calculation. A real SOC of the battery at this moment is denoted as $x_0$. A node at

$$x_i = x_0 + \frac{\int I dt}{Q_m}$$

a moment i after the initial node is selected and denoted as $x_i$. may be obtained according to an SOC calculation formula. $Q_m$ represents a present chargeable capacity of the cell. $\int I dt$ represents a charged capacity from x0 to xi, which is obtained through accumulative charged capacity calculation or calculation according to a current-time ampere-hour integration method on the cloud. Then, an estimated electromotive force value at the moment i is $EMF'(x_i) = U(x_i) - I(x_i) \cdot R(x_i, T, I(x_i))$. $EMF'(x_i)$ is a function of $x_0$ and $Q_m$. $U(x_i)$ and $I(x_i)$ respectively represent a voltage and a current at the moment i. $R(x_i, T, I(x_i))$ represents an estimated internal resistance value at the moment i, and a value thereof is calculated through interpolation according to an R (SOC, I, T) table obtained in a previous performance test. An electromotive force value at the moment i may be calculated as $EMF(x_i)$ according to the EMF curve obtained through testing.

**Step** S320: Construct a target loss function according to the first relational expression and a preset second relational expression between the state of charge and the electromotive force, and perform optimization according to the target loss function, to obtain an optimal chargeable capacity of the corresponding charging segment when the target loss function reaches a minimum value.

In an embodiment, construction of the target loss function according to the first relational expression and the preset second relational expression between the state of charge and the electromotive force and optimization according to the target loss function includes:

constructing the target loss function according to a square difference between the first relational expression and the second relational expression; and

using initial states of charge and rated capacities of the charging segments that are uploaded by a system at an initial moment as start nodes for calculation, and calculating optimal initial states of charge and optimal chargeable capacities corresponding to the charging segments according to a gradient descent method, so that a value of the target loss function is minimized.

Specifically, a plurality of charging moment points are separately selected. $x_0$ and $Q_m$ are calculated by using a method of finding an optimal solution.

The method of finding an optimal solution is not limited. The following uses an example to describe a solving process, but finding an optimal solution is not limited to this method. A loss function is set as

$$L = \sum_i \frac{1}{2}\left(EMF'(x_i) - EMF(x_i)\right)^2 \qquad x_i = x_0 + \frac{\int I dt}{Q_m}$$

, where . A battery SOC and a total rated capacity that are uploaded at the initial moment are used as the start nodes for calculation, and $x_0$ and $Q_m$ are calculated according to the gradient descent method, so that the loss function L is minimized.

**Step** S330: Determine a present state of health of a battery pack according to optimal chargeable capacities of the charging segments, where the battery pack includes a plurality of battery cells.

In an embodiment, determining of the present state of health of the battery pack according to the optimal chargeable capacities of the charging segments includes:

performing filtering based on optimal charged capacities of the charging segments to obtain a filtered charged capacity of the battery pack; and

determining the present state of health of the battery pack according to a ratio of the filtered charged capacity of the battery pack to a preset rated capacity of the battery pack.

Specifically, all the cells are calculated in a same manner to obtain initial SOCs of the cells as

$$x_0 = [x_0^1, x_0^2 \ldots x_0^k]$$ and charged capacities of the cells as $Q_m = $ $[Q_m^1, Q_m^2 \ldots Q_m^k]$ in this charging segment, and a present total chargeable capacity is calculated as $$Q_{pack_m} = \min(x_0^i \cdot Q_m^i) + \min((1 - x_0^k) \cdot Q_m^k$$ .

$Q_{pack_m}$ of each charging segment is calculated. A present total battery chargeable capacity is calculated by using

$$SOH = \frac{Q'_{pack_m}}{Q_r}$$

a specific filtering method. A present state of health of the power battery is calculated according to a definition of the SOH. $Q'_{pack_m}$ represents the filtered capacity of the battery pack. The filtering method may be moving average, Kalman filtering, or the like. $Q_r$ is a theoretical rated capacity of the power battery.

In an embodiment, before the present state of health of the battery pack is determined according to the ratio of the filtered charged capacity of the battery pack to the preset rated capacity of the battery pack, the method further includes:

obtaining charging data of the battery pack within a preset use period in which the battery pack is just put into use;
obtaining a total capacity of the battery pack according to the charging data of the battery pack; and
updating the rated capacity of the battery pack according to the total capacity to complete capacity calibration.

Specifically, the rated capacity is obtained from a vehicle manufacturer or a battery manufacturer. In addition, in an early stage of vehicle use, the method is used to calculate and update the total capacity of the battery pack, thereby avoiding a difference in battery rated capacity calculation that is caused by inconsistency, and ensuring that calculation is performed for the vehicle individually to improve accuracy.

In an embodiment, after the present state of health of the battery pack is determined according to the optimal chargeable capacities of the charging segments, the method further includes:

obtaining charging data of a latest charging segment of the battery pack, and determining a present state of charge corresponding to the battery according to the charging data of the latest charging segment and the present state of health; and
outputting the present state of charge and the present state of health to a vehicle-side battery management system.

In an embodiment, determining of the present state of charge of the corresponding battery according to the charging data of the latest charging segment and the present state of health includes:

determining a present chargeable capacity of the battery according to a product of the present state of health and a preset rated battery capacity;
determining an accumulative charged capacity of the battery pack in the latest charging segment according to the charging data of the latest charging segment; and
calculating the present state of charge according to the present chargeable capacity and the accumulative charged capacity.

Specifically, a present accurate initial SOC value (that is, the present state of charge) of the battery is calculated according to a present calculated SOH value by using the latest charging segment, and the initial SOC value and the calculated SOH value of the vehicle are transmitted back to the vehicle battery management system (BMS). The BMS updates, according to a cloud calculation result, an SOH value and the calculated initial SOC value, to ensure accurate estimation and effective control of the vehicle BMS for a battery state.

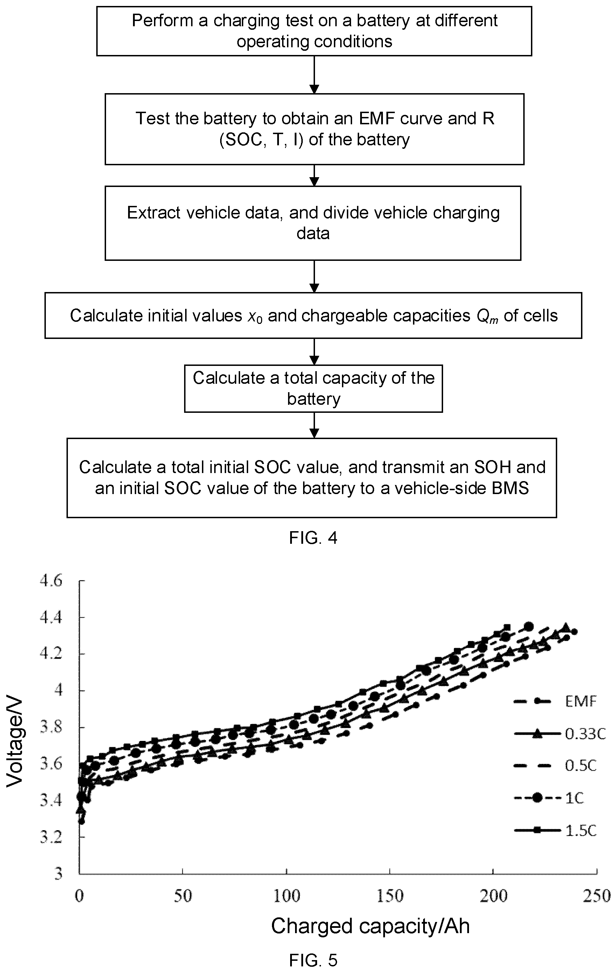

FIG. 4 is a schematic flowchart of overall estimation of a state of health of a battery according to another embodiment of this application. During project development, the capacity of the battery at the standard operating condition is tested, the constant-current charging curves of the battery at different temperatures and different current conditions are obtained through testing, and the temperatures, charging currents, charged capacities, and voltages of the battery are recorded, where the temperatures and the charging current ranges should be greater than the temperature interval for battery use, and the charging currents should be set more densely in the small current interval, to ensure accuracy of calculating the electromotive force curve subsequently. The electromotive force-capacity curve (EMF curve) of the battery is estimated by using the extrapolation estimation method according to the formula U=EMF+I·R (SOC, T, I), and the value R (SOC, T, I) of the battery internal resistance at different SOCs, different temperatures, and different current conditions is calculated according to the charging curves and the EMF curves. Specifically, FIG. 5 is a schematic diagram of calculating different charging curves and electromotive forces of a battery at a specific temperature according to an embodiment of this application.

Further, the charging data uploaded by the vehicle to the cloud platform of the Internet of Vehicles is extracted. Extracted fields include "current", "voltage", "time", "battery SOC", "accumulative charged capacity", and the like. Data cleaning is performed on the extracted fields to remove invalid data. The charging data is divided, each consecutive charging time period is used as a charging segment, m charging segments are obtained through division, these charging segments are sorted by time, and serial numbers are sequentially $1,2,\cdots,m$.

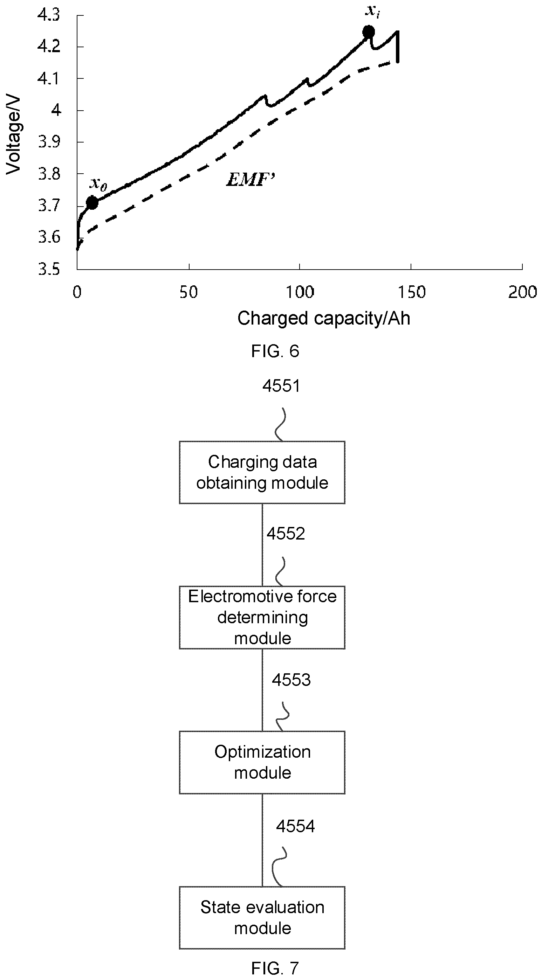

FIG. 6 is a schematic diagram of calculating a capacity of a battery cell according to an embodiment of this application. Each cell is separately calculated for the data during each time of charging, $R(SOC, T, I)$ is obtained through an initial performance test, and a relationship between an estimated EMF curve value EMF' of the cell and an SOC of the cell in a current charging segment is estimated according to present temperature T and current I. Initial charging SOCs and cell chargeable capacities Qm of different cells are calculated according to the EMF curve of the initial performance test and the EMF' curve of the charging segment in the manner of finding an optimal solution. All the cells are calculated in the same manner, to obtain the initial SOCs of the cells as $x_0 = [x_0^1, x_0^2 \ldots x_0^k]$ and the charged capacities of the cells as

$Q_m = [Q_m^1, Q_m^2 \ldots Q_m^k]$ in this charging segment, and the present total chargeable capacity

$Q_{pack_m} = \min(x_0^i \cdot Q_m^i) + \min((1 - x_0^k) \cdot Q_m^k)$ is calculated. $Q_{pack_m}$ of each charging segment is calculated, the present total battery chargeable capacity is calculated according to the specific filtering method, and the present state of health $SOH = \frac{Q'_{pack_m}}{Q_r}$ of the power battery is calculated according to the definition of the SOH. $Q_r$ is a theoretical rated capacity of the power battery, and may be obtained from the vehicle manufacturer or the battery manufacturer. In addition, in the early stage of vehicle use, the method is used to calculate and update the total capacity of the battery pack, thereby avoiding the difference in battery rated capacity calculation that is caused by inconsistency, and ensuring that calculation is performed for the vehicle individually to improve accuracy. The present accurate initial SOC value of the battery is calculated according to the present calculated SOH value by using the latest charging segment, and the initial SOC value and the calculated SOH value of the vehicle are transmitted back to the vehicle battery management system (BMS). The BMS updates, according to the cloud calculation result, the SOH value and the calculated initial SOC value, to ensure accurate estimation and effective control of the vehicle BMS for the battery state.

FIG. 7 is a module diagram of a system for estimating a state of health of a battery according to an embodiment of this application. The system includes: a charging data obtaining module 4551, configured to obtain charging data of battery cells in a plurality of charging segments within a preset time period, where each charging segment corresponds to one consecutive charging time period; an electromotive force determining module 4552, configured to determine a first relational expression between a state of charge and an electromotive force in a corresponding charging segment according to the charging data; an optimization module 4553, configured to construct a target loss function according to the first relational expression and a preset second relational expression between the state of charge and the electromotive force, and perform optimization according to the target loss function, to obtain an optimal chargeable capacity of the corresponding charging segment when the target loss function reaches a minimum value; and a state evaluation module 4554, configured to determine a present state of health of a battery pack according to optimal chargeable capacities of the charging segments, where the battery pack includes a plurality of battery cells.

In an embodiment, after determining the present state of health of the battery pack according to the optimal chargeable capacities of the charging segments, the state evaluation module 4554 is further configured to: obtain charging data of a latest charging segment of the battery pack, and determine a present state of charge corresponding to the battery pack according to the charging data of the latest charging segment and the present state of health; and output the present state of charge and the present state of health to a vehicle-side battery management system.

In an embodiment, that the state evaluation module 4554 is further configured to determine a present state of charge corresponding to the battery pack according to the charging data of the latest charging segment and the present state of health includes: determining a present chargeable capacity of the battery pack according to a product of the present state of health and a preset rated battery capacity; determining an accumulative charged capacity of the battery pack in the latest charging segment according to the charging data of the latest charging segment; and calculating the present state of charge according to the present chargeable capacity and the accumulative charged capacity.

In an embodiment, the system further includes a test data obtaining module, configured to: before the charging data of the battery cells in the plurality of charging segments within the preset time period is obtained, obtain test data of batteries at a standard operating condition, where the test data includes charged capacities and voltages of the battery cells at different temperatures and currents, and determine states of charge of the battery cells at a corresponding time node according to the charged capacities; generate voltage curves at different temperatures, currents, and states of charge according to the voltages in the test data; determine electromotive force curves corresponding to the battery cells in different states of charge according to the voltage curves; and determine battery cell internal resistances at different temperatures, currents, and states of charge according to differences between the electromotive force curves and the voltage curves.

In an embodiment, that the state evaluation module 4554 is further configured to determine electromotive force curves corresponding to the battery cells in different states of charge according to the voltage curves includes: performing interpolation on the voltage curves to obtain curves at different temperatures and a current of zero as the electromotive force curves in different states of charge.

In an embodiment, that the electromotive force determining module 4552 is further configured to determine a first relational expression between a state of charge and an electromotive force in a corresponding charging segment according to the charging data includes: obtaining a node of a charging start stage of each charging segment as an initial node, and obtaining a real state of charge at the initial node as an initial state of charge; determining states of charge corresponding to different time nodes of the charging segment according to the initial state of charge, an accumulative charged capacity, and battery chargeable capacities at different time nodes, where the accumulative charged capacity is obtained through ampere-hour integration; determining battery cell internal resistances at corresponding time nodes according to the states of charge, currents, and temperatures at different time nodes; and determining electromotive force values at the corresponding time nodes according to the battery cell internal resistances, currents, and corresponding voltage values at the corresponding time nodes, to obtain the first relational expression between the state of charge and the electromotive force in the corresponding charging segment, where the initial state of charge, the currents, the voltage values, and the temperatures are included in charging data of the corresponding charging segment.

In an embodiment, that the state evaluation module 4554 is further configured to determine a present state of health of a battery pack according to optimal chargeable capacities of the charging segments includes: performing filtering based on optimal charged capacities of the charging segments to obtain a filtered charged capacity of the battery pack; and determining the present state of health of the battery pack according to a ratio of the filtered charged capacity of the battery pack to a preset rated capacity of the battery pack.

In an embodiment, before determining the present state of health of the battery pack according to the ratio of the filtered charged capacity of the battery pack to the preset rated capacity of the battery pack, the state evaluation module 4554 is further configured to: obtain charging data of the battery pack within a preset use period in which the battery pack is just put into use; obtain a total capacity of the battery pack according to the charging data of the battery pack; and update the rated capacity of the battery pack according to the total capacity to complete capacity calibration.

In an embodiment, that the optimization module 4553 is further configured to construct a target loss function according to the first relational expression and a preset second relational expression between the state of charge and the electromotive force, and perform optimization according to the target loss function includes: constructing the target loss function according to a square difference between the first relational expression and the second relational expression; and using initial states of charge and rated capacities of the charging segments that are uploaded by a system at an initial moment as start nodes for calculation, and calculating optimal initial states of charge and optimal chargeable capacities corresponding to the charging segments according to a gradient descent method, so that a value of the target loss function is minimized.

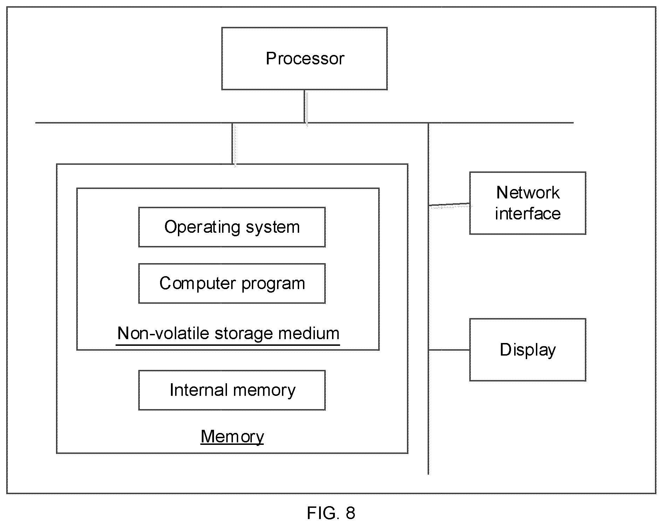

The foregoing system for estimating a state of health of a battery may be implemented in a form of a computer program, and the computer program may run on a computer device shown in FIG. 8. The computer device includes a memory, a processor, and a computer program stored in the memory and capable of running on the processor.

The modules in the foregoing system for estimating a state of health of a battery may be completely or partially implemented through software, hardware, and a combination thereof. The foregoing modules may be embedded in a memory of a terminal in a hardware form or independent of a memory of a terminal, or may be stored in a memory of a terminal in a software form, so that the processor can call and perform the operations corresponding to the foregoing modules. The processor may be a central processing unit (CPU), a microprocessor, a single-chip microcomputer, or the like.

FIG. 8 is a schematic diagram of an internal structure of a computer device according to an embodiment. A computer device is provided, including a memory, a processor, and a computer program stored in the memory and capable of running on the processor. When executing the computer program, the processor implements the following steps: obtaining charging data of battery cells in a plurality of charging segments within a preset time period, where each charging segment corresponds to one consecutive charging time period; determining a first relational expression between a state of charge and an electromotive force in a corresponding charging segment according to the charging data; constructing a target loss function according to the first relational expression and a preset second relational expression between the state of charge and the electromotive force, and performing optimization according to the target loss function, to obtain an optimal chargeable capacity of the corresponding charging segment when the target loss function reaches a minimum value; and determining a present state of health of a battery pack according to optimal chargeable capacities of the charging segments, where the battery pack includes a plurality of battery cells.

In an embodiment, after determining the present state of health of the battery pack according to the optimal chargeable capacities of the charging segments, the processor further performs the following step: obtaining charging data of a latest charging segment of the battery pack, and determining a present state of charge corresponding to the battery pack according to the charging data of the latest charging segment and the present state of health; and outputting the present state of charge and the present state of health to a vehicle-side battery management system.

In an embodiment, the determining a present state of charge corresponding to the battery pack according to the charging data of the latest charging segment and the present state of health that is implemented by the processor includes: determining a present chargeable capacity of the battery pack according to a product of the present state of health and a preset rated battery capacity; determining an accumulative charged capacity of the battery pack in the latest charging segment according to the charging data of the latest charging segment; and calculating the present state of charge according to the present chargeable capacity and the accumulative charged capacity.

In an embodiment, before obtaining the charging data of the battery cells in the plurality of charging segments within the preset time period, the processor further performs the following step: obtaining test data of batteries at a standard operating condition, where the test data includes charged capacities and voltages of the battery cells at different temperatures and currents, and determining states of charge of the battery cells at a corresponding time node according to the charged capacities; generating voltage curves at different temperatures, currents, and states of charge according to the voltages in the test data; determining electromotive force curves corresponding to the battery cells in different states of charge according to the voltage curves; and determining battery cell internal resistances at different temperatures, currents, and states of charge according to differences between the electromotive force curves and the voltage curves.

In an embodiment, the determining electromotive force curves corresponding to the battery cells in different states of charge according to the voltage curves that is implemented by the processor includes: performing interpolation on the voltage curves to obtain curves at different temperatures and a current of zero as the electromotive force curves in different states of charge.

In an embodiment, the determining a first relational expression between a state of charge and an electromotive force in a corresponding charging segment according to the charging data that is implemented by the processor includes: obtaining a node of a charging start stage of each charging segment as an initial node, and obtaining a real state of charge at the initial node as an initial state of charge; determining states of charge corresponding to different time nodes of the charging segment according to the initial state of charge, an accumulative charged capacity, and battery chargeable capacities at different time nodes, where the accumulative charged capacity is obtained through ampere-hour integration; determining battery cell internal resistances at corresponding time nodes according to the states of charge, currents, and temperatures at different time nodes; and determining electromotive force values at the corresponding time nodes according to the battery cell internal resistances, currents, and corresponding voltage values at the corresponding time nodes, to obtain the first relational expression between the state of charge and the electromotive force in the corresponding charging segment, where the initial state of charge, the currents, the voltage values, and the temperatures are included in charging data of the corresponding charging segment.

In an embodiment, the determining a present state of health of a battery pack according to optimal chargeable capacities of the charging segments that is implemented by the processor includes: performing filtering based on optimal charged capacities of the charging segments to obtain a filtered charged capacity of the battery pack; and determining the present state of health of the battery pack according to a ratio of the filtered charged capacity of the battery pack to a preset rated capacity of the battery pack.

In an embodiment, before determining the present state of health of the battery pack according to the ratio of the filtered charged capacity of the battery pack to the preset rated capacity of the battery pack, the processor further performs the following step: obtaining charging data of the battery pack within a preset use period in which the battery pack is just put into use; obtaining a total capacity of the battery pack according to the charging data of the battery pack; and updating the rated capacity of the battery pack according to the total capacity to complete capacity calibration.

In an embodiment, the constructing a target loss function according to the first relational expression and a preset second relational expression between the state of charge and the electromotive force, and performing optimization according to the target loss function that is implemented by the processor includes: constructing the target loss function according to a square difference between the first relational expression and the second relational expression; and using initial states of charge and rated capacities of the charging segments that are uploaded by a system at an initial moment as start nodes for calculation, and calculating optimal initial states of charge and optimal chargeable capacities corresponding to the charging segments according to a gradient descent method, so that a value of the target loss function is minimized.

In an embodiment, the foregoing computer device may be used as a server, including but not limited to an independent physical server, or a server cluster formed by a plurality of physical servers. The computer device may be further used as a terminal, including but not limited to a mobile phone, a tablet computer, a personal digital assistant, or a smart device. As shown in FIG. 8, the computer device includes a processor, a non-volatile storage medium, an internal memory, a display, and a network interface that are connected through a system bus.

The processor of the computer device is configured to provide computing and control capabilities, to support running of the entire computer device. The non-volatile storage medium of the computer device stores an operating system and a computer program. The computer program may be executed by the processor, to implement the method for estimating a state of health of a battery provided in the foregoing embodiments. The internal memory in the computer device provides a high-speed cache runtime environment for the operating system and computer program in the non-volatile storage medium. A display interface may display data through the display. The display may be a touchscreen, for example, a capacitive screen or an electronic screen. A corresponding instruction may be generated by receiving a tap operation that is performed on a control displayed in the touchscreen.

A person skilled in the art may understand that the structure of the computer device shown in FIG. 8 is merely a block diagram of some structures related to the solutions of this application, and does not constitute a limitation on the computer device to which the solutions of this application are applied. A specific computer device may include more or fewer components than those shown in the figure, or combine some components, or have different component arrangements.

In an embodiment, a computer-readable storage medium is provided, and a computer program is stored therein. The following steps are implemented when the computer program is executed by a processor: obtaining charging data of battery cells in a plurality of charging segments within a preset time period, where each charging segment corresponds to one consecutive charging time period; determining a first relational expression between a state of charge and an electromotive force in a corresponding charging segment according to the charging data; constructing a target loss function according to the first relational expression and a preset second relational expression between the state of charge and the electromotive force, and performing optimization according to the target loss function, to obtain an optimal chargeable capacity of the corresponding charging segment when the target loss function reaches a minimum value; and determining a present state of health of a battery pack according to optimal chargeable capacities of the charging segments, where the battery pack includes a plurality of battery cells.

In an embodiment, when the computer program is executed by the processor, after the present state of health of the battery pack is determined according to the optimal chargeable capacities of the charging segments, the following step is further included: obtaining charging data of a latest charging segment of the battery pack, and determining a present state of charge corresponding to the battery pack according to the charging data of the latest charging segment and the present state of health; and outputting the present state of charge and the present state of health to a vehicle-side battery management system.

In an embodiment, when the computer program is executed by the processor, the determining a present state of charge corresponding to the battery pack according to the charging data of the latest charging segment and the present state of health includes: determining a present chargeable capacity of the battery pack according to a product of the present state of health and a preset rated battery capacity; determining an accumulative charged capacity of the battery pack in the latest charging segment according to the charging data of the latest charging segment; and calculating the present state of charge according to the present chargeable capacity and the accumulative charged capacity.

In an embodiment, when the computer program is executed by the processor, before the charging data of the battery cells in the plurality of charging segments within the preset time period is obtained, the following step is further included: obtaining test data of batteries at a standard operating condition, where the test data includes charged capacities and voltages of the battery cells at different temperatures and currents, and determining states of charge of the battery cells at a corresponding time node according to the charged capacities; generating voltage curves at different temperatures, currents, and states of charge according to the voltages in the test data; determining electromotive force curves corresponding to the battery cells in different states of charge according to the voltage curves; and determining battery cell internal resistances at different temperatures, currents, and states of charge according to differences between the electromotive force curves and the voltage curves.

In an embodiment, when the computer program is executed by the processor, the determining electromotive force curves corresponding to the battery cells in different states of charge according to the voltage curves includes: performing interpolation on the voltage curves to obtain curves at different temperatures and a current of zero as the electromotive force curves in different states of charge.

In an embodiment, when the computer program is executed by the processor, the determining a first relational expression between a state of charge and an electromotive force in a corresponding charging segment according to the charging data includes: obtaining a node of a charging start stage of each charging segment as an initial node, and obtaining a real state of charge at the initial node as an initial state of charge; determining states of charge corresponding to different time nodes of the charging segment according to the initial state of charge, an accumulative charged capacity, and battery chargeable capacities at different time nodes, where the accumulative charged capacity is obtained through ampere-hour integration; determining battery cell internal resistances at corresponding time nodes according to the states of charge, currents, and temperatures at different time nodes; and determining electromotive force values at the corresponding time nodes according to the battery cell internal resistances, currents, and corresponding voltage values at the corresponding time nodes, to obtain the first relational expression between the state of charge and the electromotive force in the corresponding charging segment, where the initial state of charge, the currents, the voltage values, and the temperatures are included in charging data of the corresponding charging segment.

In an embodiment, when the instruction is executed by the processor, the determining a present state of health of a battery pack according to optimal chargeable capacities of the charging segments includes: performing filtering based on optimal charged capacities of the charging segments to obtain a filtered charged capacity of the battery pack; and determining the present state of health of the battery pack according to a ratio of the filtered charged capacity of the battery pack to a preset rated capacity of the battery pack.

In an embodiment, when the instruction is executed by the processor, before the present state of health of the battery pack is determined according to the ratio of the filtered charged capacity of the battery pack to the preset rated capacity of the battery pack, the following step is further included: obtaining charging data of the battery pack within a preset use period in which the battery pack is just put into use; obtaining a total capacity of the battery pack according to the charging data of the battery pack; and updating the rated capacity of the battery pack according to the total capacity to complete capacity calibration.

In an embodiment, when the instruction is executed by the processor, the constructing a target loss function according to the first relational expression and a preset second relational expression between the state of charge and the electromotive force, and performing optimization according to the target loss function includes: constructing the target loss function according to a square difference between the first relational expression and the second relational expression; and using initial states of charge and rated capacities of the charging segments that are uploaded by a system at an initial moment as start nodes for calculation, and calculating optimal initial states of charge and optimal chargeable capacities corresponding to the charging segments according to a gradient descent method, so that a value of the target loss function is minimized.

A person of ordinary skill in the art can understand that all or some of the procedures of the method in the foregoing embodiment may be implemented by a computer program instructing related hardware. The program may be stored in a non-volatile computer-readable storage medium. When the program is executed, the procedures in the foregoing method embodiment may be included. The storage medium may be a magnetic disk, an optical disc, a read-only memory (Read-Only Memory, ROM), or the like.

The foregoing embodiments merely illustrate principles and effects of this application, but are not intended to limit this application. Any person skilled in the art may modify or alter the foregoing embodiments without departing from the scope of this application. Therefore, all equivalent modifications or alterations completed by a person of ordinary skill in the art without departing from the technical ideas disclosed in this application should still be covered by the claims of this application.

## Claims

1. A method for estimating a state of health of a battery, comprising:

   obtaining charging data of battery cells in a plurality of charging segments within a preset time period, wherein each charging segment corresponds to one consecutive charging time period;
   determining a first relational expression between a state of charge and an electromotive force in a corresponding charging segment according to the charging data;
   constructing a target loss function according to the first relational expression and a preset second relational expression between the state of charge and the electromotive force, and performing optimization according to the target loss function, to obtain an optimal chargeable capacity of the corresponding charging segment when the target loss function reaches a minimum value; and
   determining a present state of health of the battery pack according to optimal chargeable capacities of the plurality of the charging segments, wherein the battery pack comprises a plurality of the battery cells.

2. The method for estimating the state of health of the battery according to claim 1, after the present state of health of the battery pack is determined according to the optimal chargeable capacities of the plurality of the charging segments, further comprising:

   obtaining charging data of a latest charging segment of the battery pack, and determining a present state of charge corresponding to the battery pack according to the charging data of the latest charging segment and the present state of health; and
   outputting the present state of charge and the present state of health to a vehicle-side battery management system.

3. The method for estimating the state of health of the battery according to claim 2, wherein the determining the present state of charge corresponding to the battery pack according to the charging data of the latest charging segment and the present state of health comprises:

> determining a present chargeable capacity of the battery pack according to a product of the present state of health and a preset rated battery capacity;
> determining an accumulative charged capacity of the battery pack in the latest charging segment according to the charging data of the latest charging segment; and
> calculating the present state of charge according to the present chargeable capacity and the accumulative charged capacity.

4. The method for estimating the state of health of the battery according to claim 1, before the charging data of the battery cells in the plurality of charging segments within the preset time period is obtained, further comprising:

> obtaining test data of batteries at a standard operating condition, wherein the test data comprises charged capacities and voltages of the battery cells at different temperatures and currents, and determining states of charge of the battery cells at a corresponding time node according to the charged capacities;
> generating voltage curves at different temperatures, currents, and states of charge according to the voltages in the test data;
> determining electromotive force curves corresponding to the battery cells in different states of charge according to the voltage curves; and
> determining battery cell internal resistances at different temperatures, currents, and states of charge according to differences between the electromotive force curves and the voltage curves.

5. The method for estimating the state of health of the battery according to claim 3, wherein the determining electromotive force curves corresponding to the battery cells in different states of charge according to the voltage curves comprises:
performing interpolation on the voltage curves to obtain curves at different temperatures and a current of zero as the electromotive force curves in different states of charge.

6. The method for estimating the state of health of the battery according to claim 1 or 4, wherein the determining the first relational expression between the state of charge and the electromotive force in a corresponding charging segment according to the charging data comprises:

> selecting a node of a charging start stage of each charging segment as an initial node, and obtaining a real state of charge at the initial node as an initial state of charge;
> determining states of charge at different time nodes of the corresponding charging segment according to the initial state of charge, an accumulative charged capacity, and battery chargeable capacities at different time nodes, wherein the accumulative charged capacity is obtained through ampere-hour integration;
> determining battery cell internal resistances at corresponding time nodes according to states of charge, currents, and temperatures at different time nodes; and
> determining electromotive force values at the corresponding time nodes according to the battery cell internal resistances, currents, and corresponding voltage values at the corresponding time nodes, to obtain the first relational expression between the state of charge and the electromotive force in the corresponding charging segment, wherein the initial state of charge, the currents, the voltage values, and the temperatures are comprised in charging data of the corresponding charging segment.

7. The method for estimating the state of health of the battery according to claim 1, wherein the determining the present state of health of the battery pack according to optimal chargeable capacities of the charging segments comprises:

> performing filtering based on optimal charged capacities of the charging segments to obtain a filtered charged capacity of the battery pack; and
> determining the present state of health of the battery pack according to a ratio of the filtered charged capacity of the battery pack to a preset rated capacity of the battery pack.

8. The method for estimating the state of health of the battery according to claim 7, before the present state of health of the battery pack is determined according to the ratio of the filtered charged capacity of the battery pack to the preset rated capacity of the battery pack, further comprising:

obtaining charging data of the battery pack within a preset use period in which the battery pack is just put into use;
obtaining a total capacity of the battery pack according to the charging data of the battery pack; and
updating a rated capacity of the battery pack according to the total capacity to complete capacity calibration.

9. The method for estimating the state of health of the battery according to claim 7, wherein the constructing the target loss function according to the first relational expression and the preset second relational expression between the state of charge and the electromotive force, and performing optimization according to the target loss function comprises:

constructing the target loss function according to a square difference between the first relational expression and the second relational expression; and
using initial states of charge and rated capacities of the charging segments that are uploaded by a system at an initial moment as start nodes for calculation, and calculating optimal initial states of charge and optimal chargeable capacities corresponding to the charging segments according to a gradient descent method, so that a value of the target loss function is minimized.

10. A system for estimating a state of health of a battery, comprising:

a charging data obtaining module, configured to obtain charging data of battery cells in a plurality of charging segments within a preset time period, wherein each charging segment corresponds to one consecutive charging time period;
an electromotive force determining module, configured to determine a first relational expression between a state of charge and an electromotive force in a corresponding charging segment according to the charging data;
an optimization module, configured to construct a target loss function according to the first relational expression and a preset second relational expression between the state of charge and the electromotive force, and perform optimization according to the target loss function, to obtain an optimal chargeable capacity of the corresponding charging segment when the target loss function reaches a minimum value; and
a state evaluation module, configured to determine a present state of health of the battery pack according to optimal chargeable capacities of the plurality of the charging segments, wherein the battery pack comprises a plurality of the battery cells.

11. A computer device, comprising a memory, a processor, and a computer program stored in the memory and capable of running on the processor, wherein the method for estimating the state of health of the battery according to any one of claims 1 to 9 are implemented when the processor executes the computer program.

12. A computer-readable storage medium having a computer program stored therein, wherein the method for estimating the state of health of the battery according to any one of claims 1 to 9 are implemented when the computer program is executed by a processor.

FIG. 1

Terminal 400-2

Memory 450

Processor 410

Network interface 420

User interface 430

Output apparatus 431

Input apparatus 432

Operating system 451

Network communication module 452

Presentation module 453

Input processing module 454

System for estimating a state of health of a battery 455

Charging data obtaining module 4551

Electromotive force determining module 4552

Optimization module 4553

State evaluation module 4554

FIG. 2

S300

Obtain charging data of battery cells in a plurality of charging segments within a preset time period, where each charging segment corresponds to one consecutive charging time period

S310

Determine a first relational expression between a state of charge and an electromotive force in a corresponding charging segment according to the charging data

S320

Construct a target loss function according to the first relational expression and a preset second relational expression between the state of charge and the electromotive force, and perform optimization according to the target loss function, to obtain an optimal chargeable capacity of the corresponding charging segment when the target loss function reaches a minimum value

S330

Determine a present state of health of a battery pack according to optimal chargeable capacities of the charging segments, where the battery pack includes a plurality of battery cells

FIG. 3

Perform a charging test on a battery at different operating conditions

↓

Test the battery to obtain an EMF curve and R (SOC, T, I) of the battery

↓

Extract vehicle data, and divide vehicle charging data

↓

Calculate initial values $x_0$ and chargeable capacities $Q_m$ of cells

↓

Calculate a total capacity of the battery

↓

Calculate a total initial SOC value, and transmit an SOH and an initial SOC value of the battery to a vehicle-side BMS

FIG. 4

FIG. 5

FIG. 6

FIG. 7

FIG. 8

## INTERNATIONAL SEARCH REPORT

| International application No. |
| --- |
| **PCT/CN2023/120636** |

| **A.** | **CLASSIFICATION OF SUBJECT MATTER** |
| --- | --- |
| | G01R31/382(2019.01)i; G01R31/392(2019.01)i |

According to International Patent Classification (IPC) or to both national classification and IPC

| **B.** | **FIELDS SEARCHED** |
| --- | --- |

Minimum documentation searched (classification system followed by classification symbols)

IPC: G01R

Documentation searched other than minimum documentation to the extent that such documents are included in the fields searched

Electronic data base consulted during the international search (name of data base and, where practicable, search terms used)

损失, 最小, 充电, 电动势, emf, soc, 荷电状态, loss, charging, electromotive-force

| **C.** | **DOCUMENTS CONSIDERED TO BE RELEVANT** | |
| --- | --- | --- |

| Category* | Citation of document, with indication, where appropriate, of the relevant passages | Relevant to claim No. |
| --- | --- | --- |
| PX | CN 115616421 A (CHONGQING CHANGAN NEW ENERGY AUTOMOBILE TECHNOLOGY CO., LTD.) 17 January 2023 (2023-01-17) claims 1-12 | 1-12 |
| Y | CN 111381180 A (BEIJING SHENGKE ENERGY TECHNOLOGY CO., LTD.) 07 July 2020 (2020-07-07) description, paragraphs 86-130 and 165 | 1-12 |
| Y | CN 112550065 A (SVOLT ENERGY TECHNOLOGY CO., LTD.) 26 March 2021 (2021-03-26) description, paragraphs 84-166 | 1-12 |
| A | CN 111416165 A (HUAZHONG UNIVERSITY OF SCIENCE AND TECHNOLOGY) 14 July 2020 (2020-07-14) entire document | 1-12 |
| A | CN 109713762 A (SHENZHEN MAMMOTH TECHNOLOGY CO., LTD.) 03 May 2019 (2019-05-03) entire document | 1-12 |

| ✓ | Further documents are listed in the continuation of Box C. | ✓ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **27 December 2023** | **28 December 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**EP 4 556 921 A1**

**INTERNATIONAL SEARCH REPORT**

| International application No. |
|---|
| **PCT/CN2023/120636** |

**C. DOCUMENTS CONSIDERED TO BE RELEVANT**

| Category* | Citation of document, with indication, where appropriate, of the relevant passages | Relevant to claim No. |
|---|---|---|
| A | CN 114624596 A (BEIJING SHENGKE ENERGY TECHNOLOGY CO., LTD.) 14 June 2022 (2022-06-14)<br>entire document | 1-12 |
| A | CN 114994539 A (SHENZHEN DAOTONGHE INNOVATIVE ENERGY CO., LTD.) 02 September 2022 (2022-09-02)<br>entire document | 1-12 |
| A | US 2021247460 A1 (SAMSUNG ELECTRONICS CO., LTD.) 12 August 2021 (2021-08-12)<br>entire document | 1-12 |

Form PCT/ISA/210 (second sheet) (July 2022)

**INTERNATIONAL SEARCH REPORT**
Information on patent family members

International application No.

**PCT/CN2023/120636**

| Patent document cited in search report | | | Publication date (day/month/year) | Patent family member(s) | | | Publication date (day/month/year) |
|---|---|---|---|---|---|---|---|
| CN | 115616421 | A | 17 January 2023 | None | | | |
| CN | 111381180 | A | 07 July 2020 | None | | | |
| CN | 112550065 | A | 26 March 2021 | None | | | |
| CN | 111416165 | A | 14 July 2020 | None | | | |
| CN | 109713762 | A | 03 May 2019 | None | | | |
| CN | 114624596 | A | 14 June 2022 | None | | | |
| CN | 114994539 | A | 02 September 2022 | None | | | |
| US | 2021247460 | A1 | 12 August 2021 | WO | 2021157943 | A1 | 12 August 2021 |
| | | | | US | 11782096 | B2 | 10 October 2023 |

Form PCT/ISA/210 (patent family annex) (July 2022)